# EUROPEAN PATENT APPLICATION

(11) **EP 4 682 952 A1**
(43) Date of publication of application: **21.01.2026**
(21) Application number: 24770695.5
(22) Date of filing: 07.03.2024
(51) Int. Cl.: H01L 23/28, H01L 25/04, H01L 25/18

(54) **SEMICONDUCTOR MODULE**

(30) Priority: 14.03.2023 JP 2023039377
(71) Applicant: Shindengen Electric Manufacturing Co., Ltd., Tokyo 100-0004 (JP)
(72) Inventor: INABA Hayato, Asaka-shi Saitama 351-0015 (JP); MOCHIDUKI Takayuki, Asaka-shi Saitama 351-0015 (JP); IKEDA Takashi, Asaka-shi Saitama 351-0015 (JP)
(74) Representative: AOMB Polska Sp. z.o.o.
(86) International application number: PCT/JP2024/008711
(87) International publication number: WO 2024/190589

(57) **Abstract**

[PROBREM] To provide a semiconductor module that can prevent an adhesive from overflowing onto a mounting portion of an electronic component on a substrate when bonding a case to the substrate.

[SOLUTION] The semiconductor module of the present invention is the semiconductor module in which a case 20 is attached to a substrate 10 and the substrate 10 is sealed with resin, wherein a first projecting part 31 is provided on at least one of an opposite surface 20A of the case 20 facing the substrate 10 and an opposite surface 10A of the substrate 10 facing the case 20, and wherein an end surface 31A of the first projecting part 31 is separated from the opposite surface 20A of the case 20 or the opposite surface 10A of the substrate 10 and a separated portion serves as an adhesive portion 50 with an adhesive 40 interposed therebetween.

## Description

### TECHNICAL FIELD

The present invention relates to a semiconductor module, and more particularly to a semiconductor module in which a case is attached to an edge of a substrate, and components are mounted on the substrate inside the case and sealed with potting resin.

### BACKGROUND

In potting-type semiconductor modules, a case is attached to a substrate, and liquid potting resin is injected into the inside of the case to resin-seal components arranged on the substrate. In order to prevent the potting resin injected inside the case from leaking out to the outside, the substrate and the case are bonded together with an adhesive so that no gaps are left, but there were cases where the bonding was not sufficient.

In order to improve adhesion between the substrate (heat sink) and the case, for example, Patent Document 1 proposes a semiconductor module in which recesses and projections are provided on either one of opposite surfaces of the substrate (heat sink) and the case.

### RELATED ART DOCUMENT

### PATENT DOCUMENT

Patent Document 1: JP-A 2004-103846

### SUMMARY OF THE INVENTION

### PROBLEMS TO BE SOLVED BY THE INVENTION

However, in the above-mentioned semiconductor module, an end surface of a projecting part may come into contact with the substrate or the case, causing the adhesive to overflow onto the mounting portion of the substrate for an electronic component, resulting in contact with the electronic component arranged on the substrate and causing malfunctions.

The present invention has been made in consideration of the above-mentioned circumstances, and the object of the present invention is to provide a semiconductor module that can prevent an adhesive from overflowing onto a mounting portion of an electronic component on a substrate when bonding a case to the substrate.

### MEANS FOR SOLVING THE PROBLEMS

In order to achieve the above-mentioned object, the present invention provide a semiconductor module in which a case is attached to a substrate and the substrate is sealed with resin, wherein a first projecting part is provided on at least one of an opposite surface of the case facing the substrate and an opposite surface of the substrate facing the case, and wherein an end surface of the first projecting part is separated from the opposite surface of the case or the opposite surface of the substrate and a separated portion serves as an adhesive portion with an adhesive interposed therebetween.

According to the present invention, the first projecting part is provided on at least one of the opposite surface of the case facing the substrate and the opposite surface of the substrate facing the case, and the end surface of the first projecting portion is separated from the opposite surface of the case or the opposite surface of the substrate, and the separated portion serves as the adhesive portion with the adhesive interposed therebetween. This makes it easier for the adhesive to remain in the adhesive portion when the case is bonded to the substrate and prevents it from overflowing onto a mounting portion of an electronic component on the substrate.

By providing a recessed part on at least one of the opposite surface of the case and the opposite surface of the substrate, on a side of the mounting portion on the substrate where the electronic component is mounted from the first projecting part and/or on an opposite side from the first projecting part to the mounting portion, even if the adhesive overflows from the adhesive portion, the overflowing adhesive tends to remain in the recessed part, further preventing the adhesive from overflowing onto the mounting portion side.

By setting each of volume of the recessed part provided on the mounting portion side and volume of the recessed part provided on the opposite side to the mounting portion to be larger than volume of the adhesive portion, even if the adhesive overflows from the adhesive portion, the overflowing adhesive can be made to remain in the recessed part.

By making the surface of the first projecting part facing the opposite side of the mounting portion a tapered surface that is inclined so as to protrude from the mounting portion side toward the opposite side of the mounting portion, the overflowing adhesive can be made to flow more easily along the surface side of the first projecting part facing the opposite side of the mounting portion and overflowing onto the mounting portion side can be prevented.

By making the surface of the first projecting part facing the mounting portion a vertical surface or a tapered surface inclined so as to cut into the mounting portion from the side of the mounting portion toward the opposite side of the mounting portion, this makes it difficult for excess adhesive to flow onto the mounting part side of the first protrusion.

By providing a second projecting part on at least one of the opposite surface of the case and the opposite surface of the substrate and making a height of an end surface of the second projecting part higher than a height of the end surface of the first projecting part, when the end surface of the second projecting part contacts the opposite surface of the case or the opposite surface of the substrate, a gap is formed between the end surface of the first projecting part and the opposite surface of the case or the opposite surface of the substrate, forming the adhesive portion.

By providing a third projecting part closer to the mounting portion than the first projecting part on at least one of the opposite surfaces of the case and the opposite surfaces of the substrate, the third projecting part serves as a dam, further preventing the adhesive that has overflowed from the adhesive portion from overflowing onto the mounting portion.

### EFEECTS OF THE INVENTION

As described above, according to the present invention, it is possible to prevent the adhesive from overflowing onto the inside of the substrate when bonding the substrate and the case.

### BRIEF DESCRIPTION OF THE DRAWINGS

FIG. 1 is a diagram showing a configuration of a semiconductor module according to an embodiment of the present invention, where FIG. 1(a) is a plan view and FIG. 1(b) is a front view.
FIG. 2 is an enlarged front view showing a schematic enlargement of part A in FIG. 1, which is an adhesive portion between a substrate and a case in the semiconductor module.
FIG. 3 is a schematic diagram showing a method of bonding the substrate and the case in the semiconductor module, where FIG. 3(a) is an enlarged front view showing a state before an adhesive is applied to an end surface of a first projecting part of the case, FIG. 3(b) is an enlarged front view showing a state after the adhesive is applied to the end surface of the first projecting part of the case, and FIG. 3(c) is an enlarged front view showing a state after the substrate and the case are bonded.
FIG. 4 is an enlarged front view showing the schematic enlarged adhesion portion between the substrate and the case in the semiconductor module according to a first modified example of the present invention.
FIG. 5 is an enlarged front view showing the schematic enlarged adhesion portion between the substrate and the case in the semiconductor module according to a second modified example of the present invention.
FIG. 6 is an enlarged front view showing the schematic enlarged adhesion portion between the substrate and the case in the semiconductor module according to a third modified example of the present invention.
FIG. 7 is an enlarged front view showing the schematic enlarged adhesion portion between the substrate and the case in the semiconductor module according to a fourth modified example of the present invention.
FIG. 8 is an enlarged front view showing the schematic enlarged adhesion portion between the substrate and the case in the semiconductor module according to a fifth modified example of the present invention.
FIG. 9 is an enlarged front view showing the schematic enlarged adhesion portion between the substrate and the case in the semiconductor module according to a sixth modified example of the present invention.
FIG. 10 is an enlarged front view showing the schematic enlarged adhesion portion between the substrate and the case in the semiconductor module according to a seventh modified example of the present invention.
FIG. 11 is an enlarged front view showing the schematic enlarged adhesion portion between the substrate and the case in the semiconductor module according to an eighth modified example of the present invention.
FIG. 12 is an enlarged front view showing the schematic enlarged adhesion portion between the substrate and the case in the semiconductor module according to a ninth modified example of the present invention.
FIG. 13 is an enlarged front view showing the schematic enlarged adhesion portion between the substrate and the case in the semiconductor module according to a tenth modified example of the present invention.
FIG. 14 is an enlarged front view showing the schematic enlarged adhesion portion between the substrate and the case in the semiconductor module according to an eleventh modified example of the present invention.
FIG. 15 is an enlarged front view showing the schematic enlarged adhesion portion between the substrate and the case in the semiconductor module according to a twelfth modified example of the present invention.
FIG. 16 is an enlarged front view showing the schematic enlarged adhesion portion between the substrate and the case in the semiconductor module according to a thirteenth modified example of the present invention.
FIG. 17 is an enlarged front view showing the schematic enlarged adhesion portion between the substrate and the case in the semiconductor module according to a fourteenth modified example of the present invention.
FIG. 18 is an enlarged front view showing the schematic enlarged adhesion portion between the substrate and the case in the semiconductor module according to a fifteenth modified example of the present invention.
FIG. 19 is an enlarged front view showing the schematic enlarged adhesion portion between the substrate and the case in the semiconductor module according to a sixteenth modified example of the present invention.
FIG. 20 is an enlarged front view showing the schematic enlarged adhesion portion between the substrate and the case in the semiconductor module according to a seventeenth modified example of the present invention.
FIG. 21 is an enlarged front view showing the schematic enlarged adhesion portion between the substrate and the case in the semiconductor module according to an eighteenth modified example of the present invention.
FIG. 22 is an enlarged front view showing the schematic enlarged adhesion portion between the substrate and the case in the semiconductor module according to a nineteenth modified example of the present invention.
FIG. 23 is a front view of the semiconductor module according to a twentieth modification of the present invention.

### MODE FOR CARRYING OUT THE INVENTION

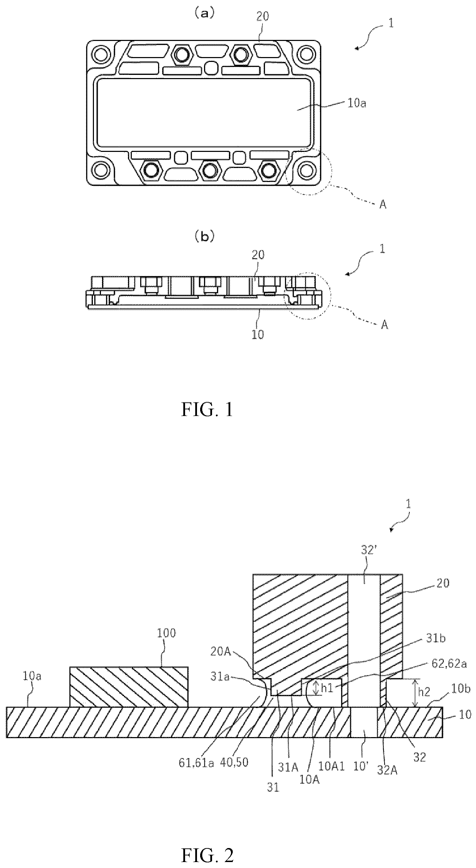

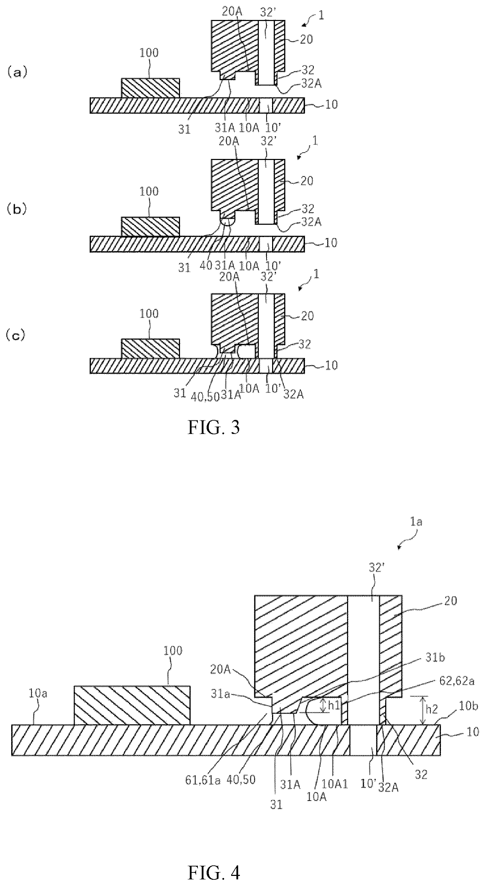

Hereinafter, embodiments of the present invention will be described in detail with reference to the drawings. FIG. 1 is a diagram showing a configuration of a semiconductor module according to an embodiment of the present invention, FIG. 2 is an enlarged front view showing a schematic enlargement of part A in FIG. 1, which is an adhesive portion between a substrate and a case in the semiconductor module, and FIG. 3 is an enlarged front view showing a method of bonding the substrate and the case in the semiconductor module.

The configuration of the semiconductor module 1 according to an embodiment of the present invention will be described with reference to FIGs. 1 and 2. The semiconductor module 1 is a semiconductor module in which a case 20 is attached to a substrate 10 and the substrate 10 is sealed with resin, wherein a first projecting part 31 is provided on at least one of an opposite surface 20A of the case 20 facing the substrate 10 and an opposite surface 10A of the substrate 10 facing the case 20, and wherein an end surface 31A of the first projecting part 31 is separated from the opposite surface 20A of the case 20 or the opposite surface 10A of the substrate 10 and a separated portion serves as an adhesive portion 50 with an adhesive 40 interposed therebetween.

More specifically, the semiconductor module 1 is a semiconductor module in which the case 20 is attached to the substrate 10 and a mounting portion 10a on the substrate 10 on which an electronic component 100 is mounted inside the case 20 is sealed with potting resin, wherein the first projecting part 31 is provided on the opposite surface 20A of the case 20 facing the substrate 10, the end surface 31A of the first projecting part 31 is set as an adhesive surface for adhering to an edge portion 10A1 of the opposite surface 10A of the substrate 10, a space is formed by separating the end surface 31A of the first projecting part 31 from the edge portion 10A1 of the opposite surface 10A of the substrate 10, and the separated space serves as the adhesive portion 50 with the adhesive 40 interposed therebetween. The surface 31a of the first projecting part 31 facing the mounting portion 10a and the surface 31b of the first projecting part 31 facing an opposite side 10b of the mounting portion 10a are both vertical surfaces. The substrate 10 is rectangular. The case 20 is a substantially rectangular ring-shaped frame.

Further, the semiconductor module 1 has recessed parts 61, 62 on at least one of the opposite surface 20A of the case 20 and the opposite surface 10A of the substrate 10, on the side of the mounting portion 10a on the substrate 10 where the electronic component 100 is mounted from the first projecting part 31 and/or on the opposite side 10b from the first projecting part 31 to the mounting portion 10a.

More specifically, in the semiconductor module 1, the recessed parts 61, 62 are provided on the opposite surface 20A of the case 20 on the side of the mounting portion 10a on the substrate 10 where the electronic component 100 is mounted from the first projecting part 31, and on the opposite side 10b from the first projecting part 31 to the mounting portion 10a. The recessed parts 61, 62 function as outflow portions through which the adhesive 40 that overflows from the adhesive portion 50 flows out.

Furthermore, in the semiconductor module 1, volume of the recessed part 61 provided on the side of the mounting portion 10a and volume of the recessed part 62 provided on the opposite side 10b to the mounting portion 10a are each set to be larger than volume of the adhesive portion 50.

More specifically, in the semiconductor module 1, the volume of a space 61a formed between the recessed part 61 provided on the side of the mounting portion 10a and the edge portion 10A1 of the opposite surface 10A of the substrate 10 and the volume of a space 62a formed between the recessed part 62 provided on the opposite side 10b of the mounting portion 10a and the edge portion 10A1 of the opposite surface 10A of the substrate 10 are each set to be larger than the volume of the adhesive portion 50.

Here, in the semiconductor module 1, a second projecting part 32 is provided on at least one of the opposite surface 20A of the case 20 and the opposite surface 10A of the substrate 10, and a height h2 of an end surface 32A of the second projecting part 32 is made higher than a height h1 of the end surface 31A of the first projecting part 31.

More specifically, in the semiconductor module 1, the second projecting part 32 is provided on the opposite surface 20A of the case 20 via the recessed part 62, and the height h2 of the end surface 32A of the second projecting part 32 is made higher than the height h1 of the end surface 31A of the first projecting part 31. Note that the second projecting part 32 and the edge portion 10A1 of the substrate 10 are provided with through-holes 32', 10' that penetrate and communicate with each other. The through-holes 32', 10' can be used to fasten the substrate 10 and the case 20 together by inserting fasteners such as bolts through them.

Next, a method for bonding the substrate 10 and the case 20 in the semiconductor module 1 will be described with reference to FIG. 3.

First, as shown in FIG. 3(a), the substrate 10 and the case 20 are separated from each other. Next, as shown in FIG. 3(b), the adhesive is applied to the end surface 31A of the first projecting part 31. Then, as shown in FIG. 3(c), the substrate 10 and the case 20 are bonded together. This bonding is performed by grounding the end surface 32A of the second projecting part 32 to the opposite surface 10A of the substrate 10.

That is, in the semiconductor module 1, the second projecting part 32 is provided on the opposite surface 20A of the case 20, and the height h2 of the end surface 32A of the second projecting part 32 is made higher than the height h1 of the end surface 31A of the first projecting 31. As a result, when the end surface 32A of the second projecting part 32 is grounded to the opposite surface 10A of the substrate 10, the end surface 31A of the first projecting part 31 and the opposite surface 10A of the substrate 10 are separated from each other to form the space and the adhesive portion 50 can be formed.

That is, in the semiconductor module 1, the first projecting part 31 is provided on the opposite surface 20A of the case 20 facing the substrate 10, the end surface 31A of the first projecting part 31 is separated from the opposite surface 10A of the substrate 10, and the separated portion serves as the adhesive portion 50 with the adhesive 40 interposed therebetween, so that when the case 20 is bonded to the substrate 10, the adhesive 40 is more likely to remain at the adhesive portion 50 and it is possible to prevent the adhesive 40 from overflowing onto the side of the mounting portion 10a of the electronic component 100 on the substrate 10. When the end surface 31A of the first projecting part 31 and the opposite surface 10A of the substrate 10 are bonded with a gap therebetween as described above, adhesion can be improved compared to when the end surface 31A of the first projecting part 31 is bonded to the opposite surface 10A of the substrate 10 without any gap between them and the end surface 31A of the first projecting part 31 is grounded to the opposite surface 10A of the substrate 10.

Further, on the opposite surface 20A of the case 20, the recessed parts 61, 62 are provided on the side of the mounting portion 10a on the substrate 10 on which the electronic component 100 is mounted from the first projecting part 31, and on the opposite side 10b from the first projecting part 31 to the mounting portion 10a. As a result, even if the adhesive 40 overflows from the adhesive portion 50, the overflowing adhesive 40 is more likely to remain in the recessed parts 61, 62, thereby further preventing the adhesive 40 from overflowing onto the side of the mounting portion 10a.

Furthermore, the volume of the recessed part 61 provided on the side of the mounting portion 10a and the volume of the recessed part 62 provided on the opposite side 10b of the side of the mounting portion 10a are each set to be larger than the volume of the adhesive portion 50, so that even if the adhesive 40 overflows from the adhesive portion 50, the overflowing adhesive 40 can be made to remain in the recessed parts 61, 62.

It should be noted that the present invention is not limited to the above-described embodiment, and various modifications and applications are possible within the scope of the invention as defined in the claims.

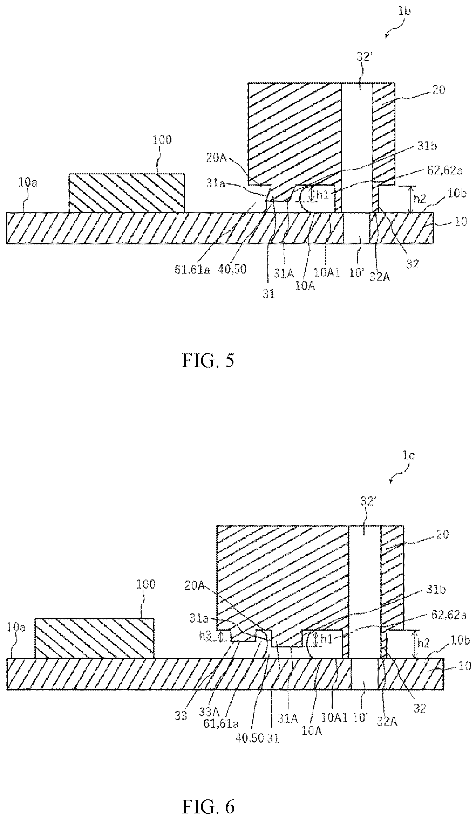

For example, in the above-described embodiment, the surface 31a of the first projecting part 31 facing the mounting portion 10a and the surface 31b of the first projecting part 31 facing the opposite side 10b of the mounting portion 10a are both vertical surfaces. However, as in the semiconductor module 1a of the first modified example shown in FIG. 4, the surface 31a of the first projecting part 31 facing the mounting portion 10a may be a vertical surface, while the surface 31b of the first projecting part 31 facing the opposite side 10b of the mounting portion 10a may be a tapered surface that rises and slopes so as to protrude from the side of the mounting portion 10a toward the opposite side 10b of the mounting portion 10a. By forming the surface in a tapered shape in this manner, the overflowing adhesive 40 can easily flow out along the side of the surface 31b of the first projecting part 31 facing the opposite side 10b of the mounting portion 10a, and overflowing to the side of the mounting portion 10a can be suppressed. Also, as in the semiconductor module 1b of the second modified example shown in FIG. 5, the side of the surface 31b of the first projecting part 31 facing the opposite side 10b of the mounting portion 10a may be a tapered surface that rises and slopes so as to protrude from the side of the mounting portion 10a toward the opposite side 10b of the mounting portion 10a, while the side of the surface 31a of the first projecting part 31 facing the mounting portion 10a may be a tapered surface that rises and slopes so as to cut into the side of the mounting portion 10a toward the opposite side 10b of the mounting portion 10. By forming such a tapered surface, it is possible to make it difficult for the overflowing adhesive 40 to overflow onto the side of the mounting portion 50 of the first projecting part 31.

Further, as in the semiconductor module 1c of the third modified example shown in FIG. 6, a third projecting part 33 may be provided on the opposite surface 20A of the case 20, closer to the mounting portion 10a than the first projecting part 31. By providing the third projecting part 33 in this way, the third projecting part 33 serves as a dam, further preventing the adhesive 40 that overflows from the adhesive portion 50 from overflowing onto the mounting portion 10a.

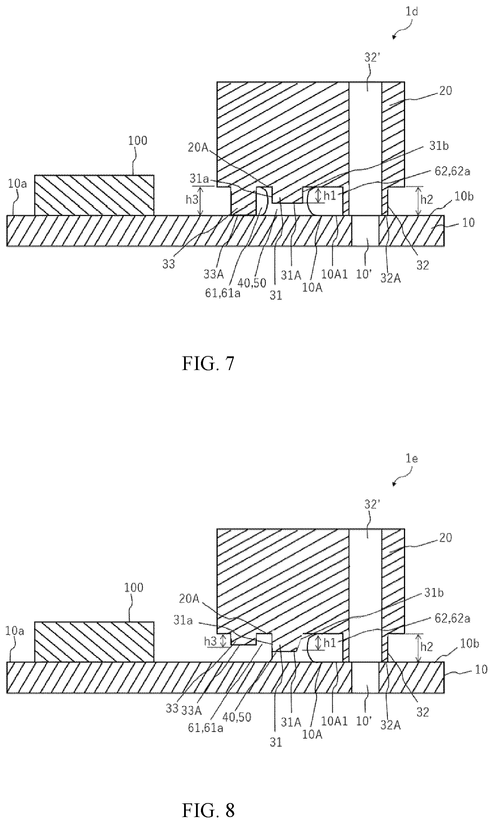

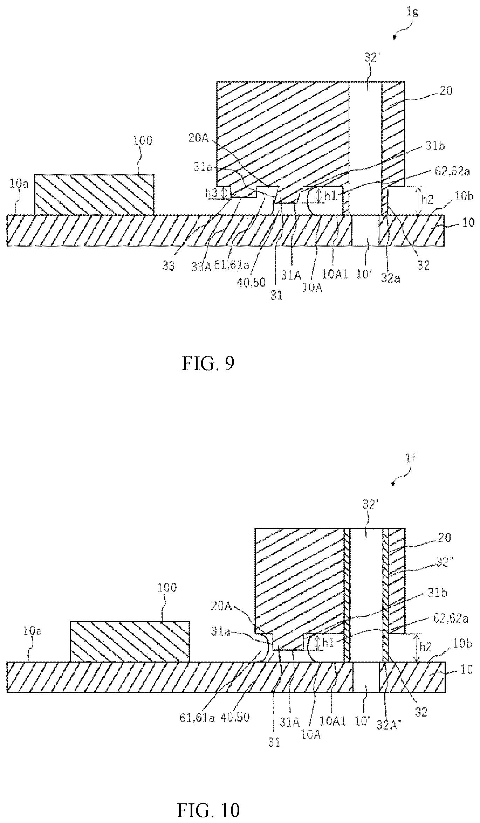

In FIG. 6, a height h3 of an end surface 33A of the third projecting part 33 is lower than the height h1 of the end surface 31A of the first projecting part 31. However, as in the semiconductor module 1d of the fourth modified example shown in FIG. 7, the height h3 of the end surface 33A of the third projecting part 33 may be higher than the height h1 of the end surface 31A of the first projecting part 31. Further, the height h3 of the end surface 33A of the third projecting part 33 may be equal to or greater than the height h2 of the end surface 32A of the second projecting part 32. In this way, by making the height h3 of the end surface 33A of the third projecting part 33 equal to or greater than the height h2 of the end surface 32A of the second projecting part 32, the third projecting part 33 can function as the dam and perform a function equivalent to that of the second projecting part 32. In this case, the second projecting part 32 may be omitted. In addition, the surface 31a of the first projecting part 31 facing the side of the mounting portion 10a of the semiconductor module 1d of the fourth modified example shown in FIG. 7 and the surface 31b of the first projecting part 31 facing the opposite side 10b of the mounting portion 10a are both vertical surfaces. However, as in the semiconductor module 1e of the fifth modified example shown in FIG. 8, while having the third projecting part 33, the surface 31a of the first projecting part 31 facing the side of the mounting portion 10a is a vertical surface, and the surface 31b of the first projecting part 31 facing the opposite side 10b of the mounting portion 10a may be a tapered surface that rises and slopes so as to protrude from the side of the mounting portion 10a toward the opposite side 10b of the mounting portion 10a. Further, as in the semiconductor module 1f of sixth modified example shown in FIG. 9, while having the third projecting part 33, the surface 31b of the first projecting part 31 facing the opposite side 10b of the mounting portion 10a may be a tapered surface that rises and slopes so as to protrude from the side of the mounting portion 10a toward the opposite side 10b of the mounting portion 10a, and the surface 31a of the first projecting part 31 facing the mounting portion 10a may be a tapered surface that is inclined upward so as to cut into the mounting portion 10 from the side of the mounting portion 10a toward the opposite side 10b of the mounting portion 10.

Further, as in the semiconductor module 1g of seventh modified example shown in FIG. 10, a washer 32" may be inserted into the through-hole 32', the side of the end surface 32A" of the washer 32" facing the substrate 10 may be made to protrude toward the substrate 10, and this protruding portion may be formed as the second projecting part 32 provided on the opposite surface 20A of the case 20.

That is, by making the height h2 of the end surface 32A of the second projecting part 32 formed by the washer 32" higher than the height h1 of the end surface 31A of the first projecting part 31 as described above, when the end surface 32A of the second projecting part 32 contacts the opposite surface 10A of the substrate 10, a gap is formed between the end surface 31A of the first projecting part 31 and the opposite surface 10A of the substrate 10, thereby forming the adhesive portion 50.

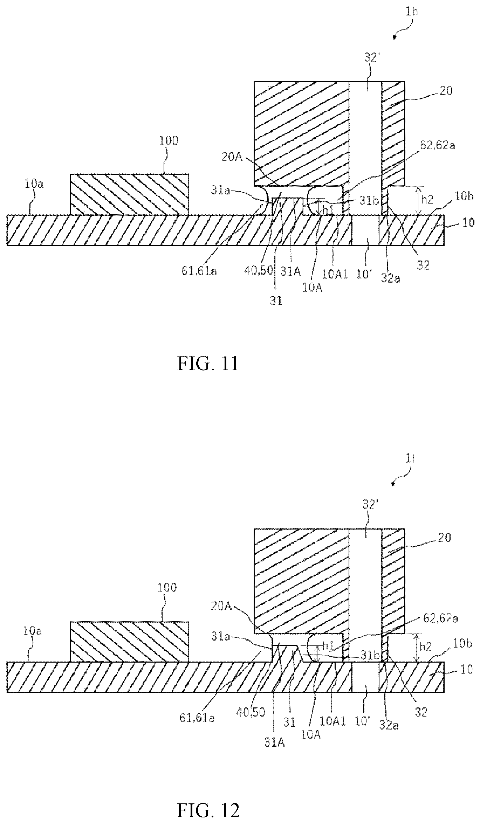

Furthermore, as shown in FIGs. 11-16, the first to third projecting parts 31 to 33 may be provided on the side of the substrate 10.

That is, in the semiconductor module 1h of the eighth modified example shown in FIG. 11, the first projecting part 31 is provided on the opposite surface 10 of the substrate 10 facing the case 20, the end surface 31A of the first projecting part 31 is separated from the facing surface 20 of the case 20, and the separated portion serves as the adhesive portion 50 with the adhesive 40 interposed therebetween. Further, in the semiconductor module 1h, the recessed parts 61, 62 are provided on the opposite surface 10 of the substrate 10 on the side of the mounting portion 10a on the substrate 10 where the electronic component 100 is mounted from the first projecting part 31 and on the opposite side 10b of the mounting portion 10a from the first projecting part 31. Furthermore, in the semiconductor module 1h, the second projecting part 32 is provided on the opposite surface 10A of the substrate 10, and the height h2 of the end surface 32A of the second projecting part 32 is made higher than the height h1 of the end surface 31A of the first projecting part 31. Note that the surface 31a of the first projecting part 31 facing the mounting portion 10a and the surface 31b of the first projecting part 31 facing the opposite side 10b of the mounting portion 10a are both vertical surfaces.

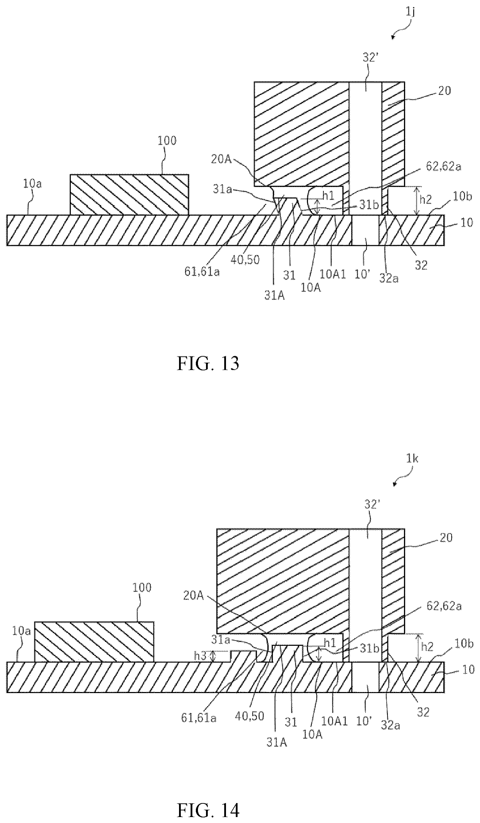

Further, in the semiconductor module 1i of the ninth modified example shown in FIG. 12, the surface 31a of the first projecting part 31 facing the side of the mounting portion 10a is a vertical surface, while the surface 31b of the first projecting part 31 facing the opposite side 10b of the mounting portion 10a is a tapered surface that slopes downward so as to protrude from the side of the mounting portion 10a toward the opposite side 10b of the mounting portion 10a. Furthermore, in the semiconductor module 1j of the tenth modified example shown in FIG. 13, the surface 31b of the first projecting part 31 facing the opposite side 10b of the mounting portion 10a is a tapered surface that slopes downward so as to protrude from the side of the mounting portion 10a toward the opposite side 10b of the mounting portion 10a, while the surface 31a of the first projecting part 31 facing the mounting portion 10a is a tapered surface that slopes downward so as to cut into the side of the mounting portion 10a toward the opposite side 10b of the mounting portion 10a.

Further, in the semiconductor module 1k of the eleventh modified example shown in FIG. 14, the third projecting part 33 is provided on the opposite surface 10A of the substrate 10, closer to the mounting portion 10a than the first projecting part 31.

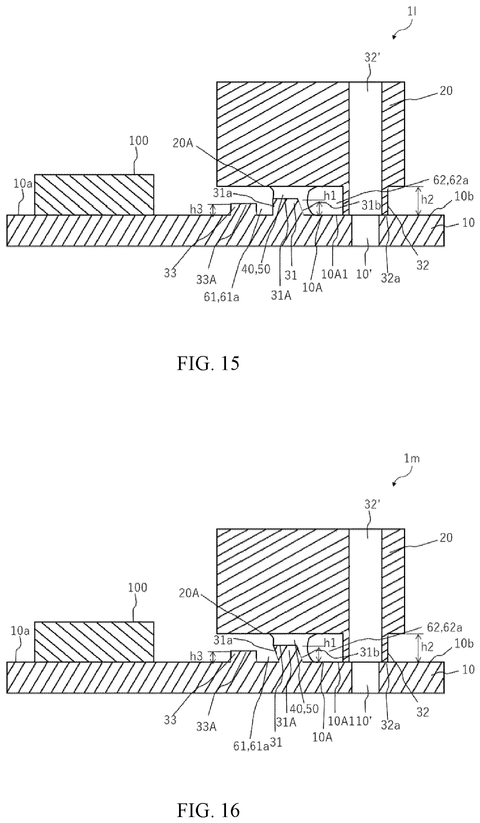

Further, in the semiconductor module 11 of the twelfth modified example shown in FIG. 15, while having the third projecting part 33, the surface 31a of the first projecting part 31 facing the mounting portion 10a is a vertical surface, and the surface 31b of the first projecting part 31 facing the opposite side 10b of the mounting portion 10a is a tapered surface that slopes downward so as to protrude from the mounting portion 10a side toward the opposite side 10b of the mounting portion 10a.

Further, in the semiconductor module 1m of the thirteenth modified example shown in FIG. 16, while having the third projecting part 33, the surface 31b of the first projecting part 31 facing the opposite side 10b of the mounting portion 10a is a tapered surface that slopes downward so as to protrude from the side of the mounting portion 10a toward the opposite side 10b of the mounting portion 10a, and the surface 31a of the first projecting part 31 facing the mounting portion 10a is a tapered surface that slopes downward so as to cut into the mounting portion 10a side toward the opposite side 10b of the mounting portion 10.

In addition, in FIGs. 14-16, the height h3 of the end surface 33A of the third projecting part 33 is lower than the height h1 of the end surface 31A of the first projecting part 31, but the height h3 of the end surface 33A of the third projecting part 33 may be higher than the height h1 of the end surface 31A of the first projecting part 31. Also, the height h3 of the end surface 33A of the third projecting part 33 may be equal to or higher than the height h2 of the end surface 32A of the second projecting part 32. In this way, by making the height h3 of the end surface 33A of the third projecting part 33 equal to or higher than the height h2 of the end surface 32A of the second projecting part 32, the third projecting part 33 can function as the dam and perform the same function as the second projecting part 32. In this case, the second projecting part 32 may be omitted.

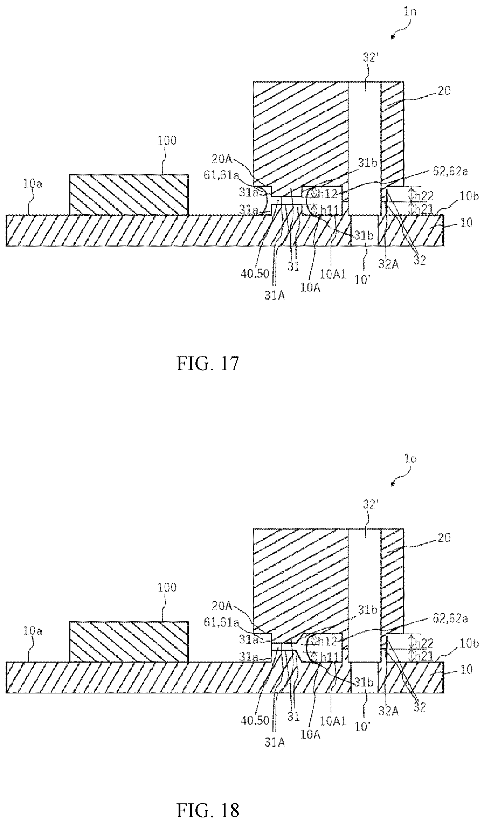

Further, as shown in FIGs. 17-22, the first to third projecting parts 31 to 33 may be provided on the substrate 10 and the case 20, respectively, so as to face each other.

That is, in the semiconductor module 1n of the fourteenth modified example shown in FIG. 17, the first projecting parts 31 and the second projecting parts 32 are provided so as to face the opposite surface 20A of the case 20 and the opposite surface 10A of the substrate 10, respectively. Further, the height h22 of the second projecting part 32 provided on the case 20 plus the height h21 of the second projecting part 32 provided on the substrate 10 is made higher than the height h12 of the first projecting part 31 provided on the case 20 plus the height h11 of the first projecting part 31 provided on the substrate 10. Therefore, the end surface 31A of the first projecting part 31 provided on the opposite surface 20A of the case 20 and the end surface 31A of the first projecting part 31 provided on the opposite surface 10A of the substrate 10 are separated to form a space, and the separated space can serve as the adhesive portion 50 with the adhesive 40 interposed therebetween. The surface 31a of the first projecting part 31 facing the mounting portion 10a and the surface 31b of the first projecting part 31 facing the opposite side 10b of the mounting portion 10a are both vertical surfaces.

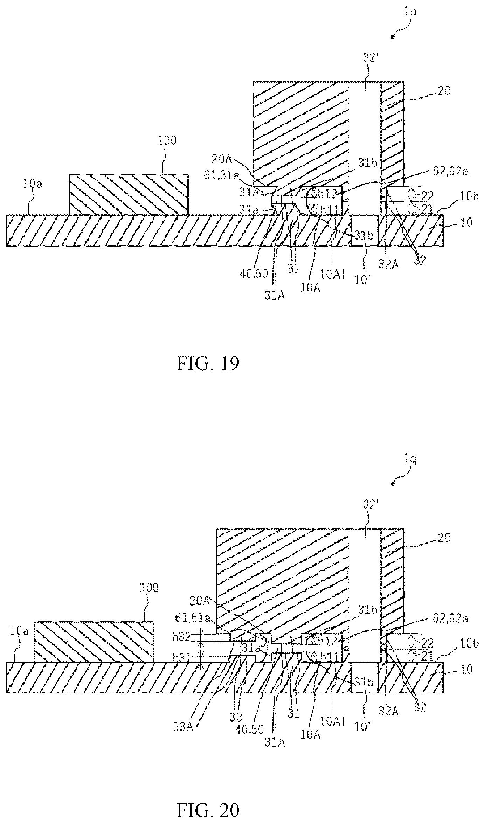

In the semiconductor module 1o of the fifteenth modified example shown in FIG. 18, the surface 31a of the first projecting part 31 facing the mounting portion 10a is a vertical surface, while the surface 31b of the first projecting part 31 facing the opposite side 10b of the mounting portion 10a is a tapered surface that is inclined so as to protrude from the side of the mounting portion 10a toward the opposite side 10b of the mounting portion 10a. In the semiconductor module 1p of the sixteenth modified example shown in FIG. 19, the surface 31b of the first projecting part 31 facing the opposite side 10b of the mounting portion 10a is a tapered surface that is inclined so as to protrude from the side of the mounting portion 10a toward the opposite side 10b of the mounting portion 10a, while the surface 31a of the first projecting part 31 facing the mounting portion 10a is a tapered surface that is inclined so as to cut into the opposite side 10b of the mounting portion 10 from the side of the mounting portion 10a.

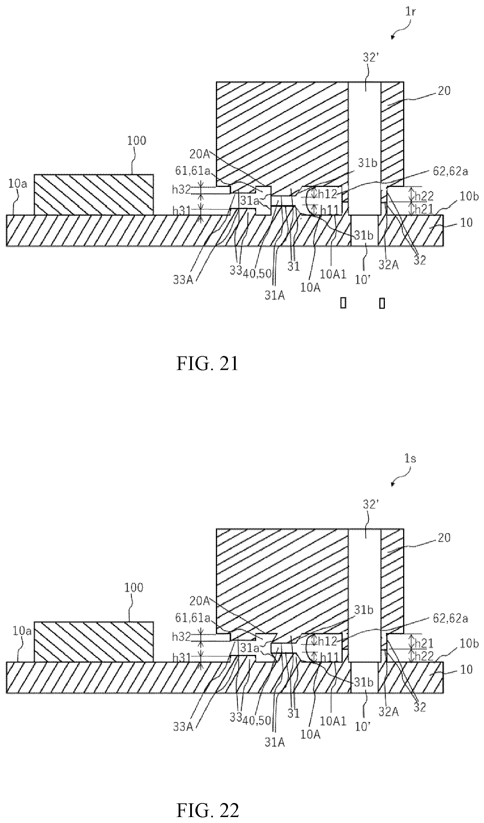

Furthermore, in the semiconductor module 1q of the seventeenth modified example shown in FIG. 20, the third projecting parts 33 are provided so as to face each of the opposite surface 20A of the case 20 and the opposite surface 10A of the substrate 10, closer to the mounting portion 10a than the first projecting part 31. The surface 31a of the first projecting part 31 facing the side of the mounting portion 10a and the surface 31b of the first projecting part 31 facing the opposite side 10b of the mounting portion 10a are both vertical surfaces. As in the semiconductor module 1r of the eighteenth modified example shown in FIG. 21, while the surface 31a of the first projecting part 31 facing the side of the mounting portion 10a is a vertical surface, the surface 31b of the first projecting part 31 facing the opposite side 10b of the mounting portion 10a may be a tapered surface that is inclined so as to protrude from the side of the mounting portion 10a toward the opposite side 10b of the mounting portion 10a. Further, as in the semiconductor module 1s of the nineteenth modified example shown in FIG. 22, while having the third projecting part 33, the surface 31b of the first projecting part 31 facing the opposite side 10b of the mounting portion 10a may be a tapered surface that is inclined so as to protrude from the side of the mounting portion 10a toward the opposite side 10b of the mounting portion 10a, and the surface 31a of the first projecting part 31 facing the mounting portion 10a may be a tapered surface that is inclined so as to cut into the side of the mounting portion 10a toward the opposite side 10b of the mounting portion 10a.

Although not shown, on the side of the mounting portion 10a from the first projecting part 31, the third projecting part 33 provided on the opposite surface 20A of the case 20 and the third projecting part 33 provided on the opposite surface 10A of the substrate 10 may be arranged so as not to face each other but to be shifted in position.

Further, FIGs. 20-22, the height h32 of the end surface 33A of the third projecting part 33 provided on the case 20 plus the height H31 of the end surface 33A of the third projecting part 33 provided on the substrate 10 is lower than the height h12 of the end surface 31A of the first projecting part 31 provided on the case 20 plus the height h11 of the end surface 31A of the first projecting part 31 provided on the substrate 10. However, the height h32 of the end surface 33A of the third projecting part 33 provided on the case 20 plus the height h31 of the end surface 33A of the third projecting part 33 provided on the substrate 10 may be higher than the height h12 of the end surface 31A of the first projecting part 31 provided on the case 20 plus the height h11 of the end surface 31A of the first projecting part 31 provided on the substrate 10.

Further, the height h32 of the end surface 33A of the third projecting part 33 provided on the case 20 plus the height h31 of the end surface 33A of the third projecting part 33 provided on the substrate 10 may be equal to or higher than the height h22 of the end surface 32A of the second projecting part 32 provided on the case 20 plus the height h21 of the end surface 32A of the second projecting part 32 provided on the substrate 10. In this way, by making the height h22 of the end surface 32A of the second projecting part 32 provided on the case 20 equal to or higher than the height h21 of the end surface 32A of the second projecting part 32 provided on the substrate 10, the third projecting part 33 can function as the dam and perform the same function as the second projecting part 32. In this case, the second projecting part 32 may be omitted.

In the above-described embodiments and modified examples, the recessed parts 61, 62 are provided on both the side of the mounting portion 10a on the substrate 10 where the electronic component 100 is mounted from the first projecting part 31 and the opposite side 10b from the first projecting part 32 to the side of the mounting portion 10a, but the required effect can be achieved with either one.

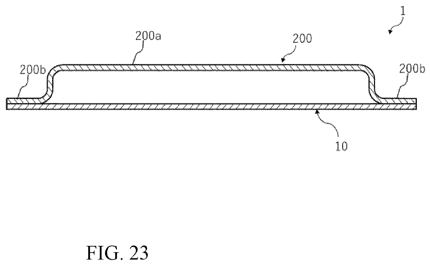

Further, in the embodiments described above, the semiconductor module 1 has the case 20 attached in a ring-like manner around the edge portion 11 of the substrate 10, and the case 20 is in a substantially rectangular ring-like frame shape with an opening 20A on the inside. However, as shown in FIG. 23, the effect of the present invention can also be achieved when the case 200 has a dome-shaped case body 200a that covers the inner opening 20A, and the ring-shaped frame part 200b is attached in a ring-like manner around the edge portion 11 of the substrate 10.

### REFFERENCE SIGNS LIST

h1, h11, h12, h2, h21, h22, h3, h31, h32: Height
1, 1a, 1b, 1c, 1d, 1e, 1f, 1g, 1h, 1i, 1j, 1k, 1l, 1m, 1n, 1o, 1p, 1q, 1r, 1s:
Semiconductor module
10: Substrate
10a: Mounting portion
10b: Opposite side
10A: Opposite surface
10A1: Edge portion
10': Through-hole
20: Case
20A: Opposite surface
31: First projecting part
31A: End surface
31a: Surface
31b: Surface
32: Second projecting part
32A: End surface
32': Through-hole
32": Washer
32A": End surface
33: Third projecting part
33A: End surface
40: Adhesive
50: Adhesive portion
61, 62: Recessed part
61a, 62a: Space
100: Electronic component
200: Case
200a: Case body
200b: Frame part

## Claims

1. A semiconductor module in which a case is attached to a substrate and the substrate is sealed with resin,
wherein a first projecting part is provided on at least one of an opposite surface of the case facing the substrate and an opposite surface of the substrate facing the case, and
wherein an end surface of the first projecting part is separated from the opposite surface of the case or the opposite surface of the substrate and a separated portion serves as an adhesive portion with an adhesive interposed therebetween.

2. The semiconductor module as claimed in claim 1, wherein a recessed part is provided on at least one of the opposite surfaces of the case and the opposite surfaces of the substrate, on a side of a mounting portion on the substrate where an electronic component is mounted from the first projecting part and/or on an opposite side from the first projecting part to the mounting portion.

3. The semiconductor module as claimed in claim 1, wherein volume of the recessed part provided on the side of the mounting portion and volume of the recessed part provided on the opposite side of the mounting portion are each set to be larger than volume of the adhesive portion.

4. The semiconductor module as claimed in claim 1, wherein a surface of the first projecting part facing the opposite side of the mounting portion is a tapered surface that is inclined so as to protrude from the side of the mounting portion toward the opposite side of the mounting portion.

5. The semiconductor module as claimed in claim 1, wherein a surface of the first projecting part facing the mounting portion is a vertical surface or a tapered surface inclined so as to cut into the mounting portion from the side of the mounting portion toward the opposite side of the mounting portion.

6. The semiconductor module as claimed in claim 1, wherein a second projecting part is provided on at least one of the opposite surface of the case and the opposite surface of the substrate and a height of the end surface of the second projecting part is made higher than a height of the end surface of the first projecting part.

7. The semiconductor module as claimed in claim 1, wherein a third projecting part is provided on at least one of the opposite surface of the case and the opposite surface of the substrate, closer to the mounting portion than the first projecting part.
